# DEMANDE DE BREVET EUROPEEN

(11) **EP 4 593 074 A1**
(43) Date de publication de la demande: **30.07.2025**
(21) Numéro de dépôt: 25152186.0
(22) Date de dépôt: 16.01.2025
(51) Int. Cl.: H01L 23/00

(54) **COMPOSANT ELECTRONIQUE COMPRENANT DES PILIERS DE CONNEXION**

(30) Priorité: 19.01.2024 FR 2400536
(71) Demandeur: STMicroelectronics International N.V., 1228 Plan-les-Ouates, Geneva (CH)
(72) Inventeur: BOUFNICHEL, Mohamed, 37380 Monnaie (FR)
(74) Mandataire: Cabinet Beaumont

(57) **Abrégé**

La présente description concerne un composant électronique (50), comme une puce électronique, comprenant un substrat semiconducteur (12) ayant des première et deuxième faces (14, 16) opposées et des piliers conducteurs électriquement (60), destinés à être connectés à un élément extérieur au composant électronique, une couche isolante (24) recouvrant la deuxième face (16) du substrat (12), une première partie des piliers conducteurs électriquement (60) se projetant en saillie depuis la couche isolante (24) et une deuxième partie des piliers conducteurs électriquement (60) traversant la couche isolante et s'étendant dans le substrat semiconducteur (12) sur une profondeur inférieure à l'épaisseur du substrat semiconducteur (12) .

## Description

### Domaine technique

La présente description concerne le domaine des composants électroniques ayant des piliers de connexion électrique, et plus particulièrement des puces électroniques ayant des piliers de connexion électrique pour être raccordées à un boîtier ou à une autre puce électronique.

### Technique antérieure

Pour connecter une puce électronique à un élément extérieur, il peut être prévu des billes ou des piliers de connexion situés sur une face de la puce électronique et connectés à des pistes conductrices de la puce électronique. Ainsi, il est possible de mettre en contact les billes ou les piliers de connexion avec des zones ou des pistes conductrices situées sur un élément extérieur, par exemple un boîtier ou une autre puce électronique.

La réduction de la taille des puces électroniques s'accompagne de la réduction de la taille de ces éléments de connexion. L'utilisation de piliers est préférée à l'utilisation de billes pour avoir un rapport d'aspect élevé, le rapport d'aspect étant le rapport entre la hauteur et le diamètre du plot de connexion.

Cependant, l'utilisation de piliers de connexion, notamment lorsqu'ils présentent un rapport d'aspect élevé et/ou lorsqu'ils sont de dimensions faibles peut présenter certains inconvénients : la fragilité des piliers de connexion, la durée et le coût élevés du procédé de fabrication du plot de connexion, ou encore le risque d'arrachement des piliers de connexion de la face de la puce électronique sur laquelle ils sont formés.

### Résumé de l'invention

Il existe un besoin d'améliorer au moins en partie certains aspects des puces électroniques comprenant des piliers de connexion.

Ce but est atteint par un composant électronique, telle qu'une puce électronique, comprenant un substrat semiconducteur ayant des première et deuxième faces opposées et des piliers conducteurs électriquement, destinés à être connectés à un élément extérieur au composant électronique, une couche isolante recouvrant la deuxième face du substrat, une première partie des piliers conducteurs électriquement se projetant en saillie depuis la couche isolante et une deuxième partie des piliers conducteurs électriquement traversant la couche isolante et s'étendant dans le substrat semiconducteur sur une profondeur inférieure à l'épaisseur du substrat semiconducteur.

Selon un mode de réalisation, la deuxième partie des piliers conducteurs électriquement est formée d'un ou plusieurs éléments cylindriques.

Selon un mode de réalisation, la deuxième partie des piliers conducteurs électriquement est formée de plusieurs éléments tubulaires disposés de manière coaxiale.

Selon un mode de réalisation, une couche isolante électriquement est disposée entre la deuxième partie des piliers conducteurs électriquement et le substrat semiconducteur.

Selon un mode de réalisation, une couche d'interface, de préférence en TiCu, est en contact avec la deuxième partie des piliers conducteurs électriquement, la couche d'interface étant disposée entre les piliers conducteurs électriquement et la couche isolante électriquement.

Selon un mode de réalisation, une zone active s'étend dans le substrat semiconducteur depuis la deuxième face et contenant au moins un composant électronique discret, chaque pilier conducteur électriquement comprenant en outre une piste de connexion s'étendant sur la deuxième face du substrat semiconducteur et connectée électriquement à la zone active.

Selon un mode de réalisation, la première partie des piliers conducteurs électriquement a une hauteur supérieure à 25 µm.

Selon un mode de réalisation, la deuxième partie des piliers conducteurs électriquement a une hauteur d'au moins 5 µm.

Ce but est également atteint par un procédé de fabrication d'un composant électronique, telle qu'une puce électronique, comprenant un substrat semiconducteur ayant des première et deuxième faces opposées et des piliers conducteurs électriquement, destinés à être connectés à un élément extérieur au composant électronique,
le procédé comprenant les étapes suivantes :
- former une couche isolante électriquement sur la deuxième face du substrat semiconducteur,
- former des ouvertures traversant la couche isolante et se prolongeant sur une partie de l'épaisseur du substrat semiconducteur,
- former la première partie des piliers conducteurs électriquement en remplissant les ouvertures par un matériau conducteur électriquement,
- former la deuxième partie des piliers conducteurs électriquement à partir de la première partie des piliers.

Selon un mode de réalisation, le procédé comprend, avant le remplissage des ouvertures par le matériau conducteur électriquement, une étape de formation d'une couche isolante électriquement dans les ouvertures.

Selon un mode de réalisation, le procédé comprend, entre l'étape de formation d'une couche isolante électriquement et l'étape de remplissage des ouvertures par le matériau conducteur électriquement, une étape de dépôt d'une couche d'interface, de préférence en TiCu, dans les ouvertures.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'une puce électronique ;
la figure 2 est une vue en coupe, partielle et schématique, d'un mode de réalisation d'une puce électronique ;
la figure 3 est une vue en coupe, partielle et schématique, d'un pilier positionné dans un substrat selon un mode de réalisation particulier d'une puce électronique ;
la figure 4, la figure 5 et la figure 6 sont des vues de dessus et en coupe, partielle et schématique, de différents piliers positionnés dans un substrat selon un mode de réalisation particulier d'une puce électronique (les pointillés représentent la délimitation des puces électroniques formées dans le substrat) ;
la figures 7A, la figure 7B, la figure 7C, la figure 7D, la figure 7E, la figure 7F, la figure 7G et la figure 7H sont chacune une vue en coupe, partielle et schématique, d'une structure obtenue à différentes étapes d'un mode de réalisation d'un procédé de fabrication de la puce électronique représentée en figure 2.

Les différents éléments des figures ne sont pas représentés à une échelle uniforme pour une meilleure lisibilité des figures.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

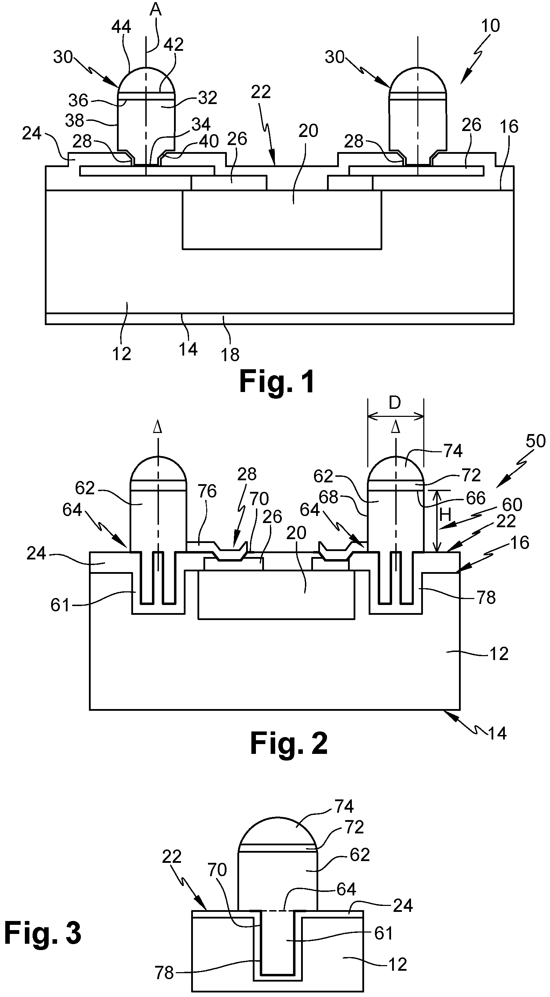

La figure 1 est une vue en coupe, partielle et schématique, d'un exemple d'une puce électronique 10.

La puce électronique 10 comprend :
- un substrat semiconducteur 12 comprenant une face inférieure 14 (première face) et une face supérieure 16 (deuxième face) ;
- une couche isolante 18 pouvant recouvrir la face inférieure 14 ;
- une zone active 20 dans le substrat 12 affleurant à la face supérieure 16, un ou des composants électroniques, non représentés, étant formés dans et/ou sur la zone active 20 ;
- une structure d'interconnexion 22 recouvrant la face supérieure 16 du substrat, la structure d'interconnexion 22 comprenant une face supérieure et une face inférieure en contact avec le substrat 12, la structure d'interconnexion comprenant une couche isolante 24 et des pistes conductrices 26 dans la couche isolante 24, certaines des pistes conductrices 26 étant au contact de la zone active 20 ;
- des ouvertures 28 dans la couche isolante 24 exposant chacune une partie de l'une des pistes conductrices 26 ; et
- des piliers de connexion 30, deux piliers de connexion étant représentés à titre d'exemple en figure 1, chaque pilier étant connecté à l'une des pistes conductrices 26.

Chaque pilier de connexion 30 comprend un tronc 32 qui s'étend selon un axe A sensiblement orthogonal à la face supérieure 16. Le tronc 32 comprend une base 34 du côté le plus proche du substrat 12, une face d'extrémité 36 opposée à la base 34 du côté le plus éloigné du substrat 12, et une paroi latérale 38 reliant la base 34 à la face d'extrémité 36. Le pilier de connexion 30 comprend en outre une couche d'interface 40 interposée entre la base 34 et la structure d'interconnexion 22. Le pilier 30 comprend, en outre, une couche de finition 42 recouvrant la face d'extrémité 36 et un bloc 44 d'un matériau de liaison recouvrant la couche de finition 42.

L'utilisation de piliers de connexion 30 tels que représentés en figure 1 peut présenter certains inconvénients. Les piliers de connexion 30 peuvent être fragiles lorsqu'ils sont de dimensions faibles ou lorsqu'ils présentent un rapport d'aspect (également appelé facteur de forme) élevé. En outre, chaque pilier de connexion 30 est lié mécaniquement à la structure d'interconnexion 22 seulement par la couche d'interface 34.

De plus, lors de la fabrication d'un tel dispositif, le procédé comprend une étape au cours de laquelle la couche d'interface 40 déposée pleine plaque est gravée après formation du pilier de connexion 30 sur celle-ci. Or, lorsque le matériau est gravé, la gravure se prolonge latéralement sous le matériau conducteur des piliers de connexion 30 (phénomène appelé 'undercut'), ce qui entraine une gravure partielle de la couche d'interface 34 disposée sous le pilier 30, depuis sa périphérie. Ceci fragilise la liaison entre le tronc 32 et la structure d'interconnexion 22. On peut alors observer une augmentation du risque d'arrachement du pilier de connexion 30 de la structure de connexion 22. Le pourcentage de surface de contact perdue augmente à mesure que le diamètre du pilier diminue.

La figure 2 est une vue en coupe, partielle et schématique, d'un exemple d'une puce électronique 50. La puce électronique 50 comprend l'ensemble des éléments de la puce électronique 10 de la figure 1 à la différence que les piliers de connexion 30 sont remplacés par des piliers de connexion 60.

Chaque pilier de connexion 60 comprend deux parties solidaires mécaniquement l'une de l'autre :
- une première partie (partie supérieure du pilier) disposée en saillie de la puce 50, de manière à permettre une connexion électrique avec un élément externe (tel qu'un boîtier ou une autre puce électronique), la première partie s'étendant ou se projetant à partir de la face supérieure de la couche isolante 24 de la structure d'interconnexion 22 recouvrant la deuxième face 16 du substrat 12,
- une deuxième partie (partie inférieure du pilier) qui traverse, de part en part, la couche isolante 24 de la structure d'interconnexion 22 ainsi qu'une partie du substrat 12, la hauteur de la deuxième partie étant inférieure à l'épaisseur du substrat 12.

Plus particulièrement, la première partie du pilier comprend un tronc 62 qui s'étend selon un axe Δ sensiblement orthogonal à la face supérieure 16 et à la face inférieure du substrat, le tronc se projetant hors de la couche isolante 24 de la structure d'interconnexion 22 positionnée sur la face supérieure 16 du substrat 12, le tronc 62 ayant une base 64 disposée au niveau de la face supérieure de la structure d'interconnexion 24, une face d'extrémité 66, positionnée hors du substrat 12, et opposée à la base 64, et une paroi latérale 68 reliant la base 64 à la face d'extrémité 66.

Une couche de finition 72 recouvre la face d'extrémité 66 et est en contact physique direct avec la face d'extrémité 66.

Un bloc 74 d'un matériau de liaison recouvre la couche de finition 72.

La base 64 de la première partie du pilier est en contact direct avec la deuxième partie du pilier.

La première partie est visible, elle dépasse du substrat. La deuxième partie est enterrée au sein du composant : elle n'est pas visible lors d'une utilisation normale du composant électronique 50. Seul un découpage du composant 50 peut permettre de l'observer.

La deuxième partie du pilier peut être formée d'un ou plusieurs éléments 61. Ces éléments sont en contact direct avec la base 64 du tronc 62 de la première partie du pilier 60.

Les éléments 61 comprennent une base (ou face inférieure), une paroi latérale et une face supérieure. La face supérieure est en contact direct avec la partie supérieure du pilier.

Les éléments 61 peuvent avoir différentes formes et/ou différentes dimensions. Les formes et/ou les dimensions peuvent être identiques ou différentes au sein d'un même pilier ou entre différents piliers.

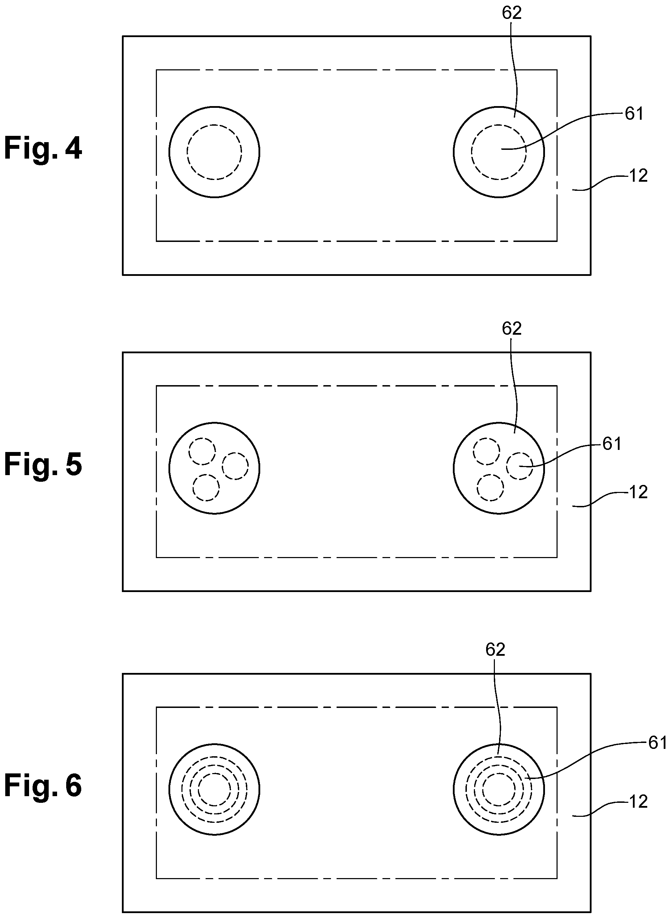

Selon différents modes de réalisation, la deuxième partie du pilier 60 peut comprendre un seul élément 61 (figures 3, 4) ou plusieurs éléments 61 (figures 2, 5 et 6).

Selon différents modes de réalisation, la deuxième partie peut être formée d'un élément 61 cylindrique (figures 3 et 4) ou de plusieurs éléments 61 cylindriques (figures 2, 5). La deuxième partie du pilier 60 peut également être formé d'un ou plusieurs éléments 61 tubulaires. Les éléments tubulaires peuvent disposés de manière coaxiale (figure 6).

La section droite d'un élément 61 ou la somme des sections droites des éléments 61 est, de préférence, inférieure à la section droite du tronc 62.

Les éléments 61 ont, de préférence, une hauteur comprise entre 5 µm et 50 µm. Ils ont, par exemple, une hauteur de 10 µm. Le diamètre moyen des éléments 61 est, de préférence, compris entre 1 µm et 40 µm. Le diamètre moyen d'un élément cylindrique est, par exemple, de 5 µm.

Par diamètre moyen, on entend le diamètre d'un élément 61 à base circulaire dont la surface est la même que celle de l'élément 61.

Chaque pilier 60 est ancré dans le substrat 12 sur une partie de l'épaisseur du substrat 12 grâce à l'élément 61 ou aux éléments 61 de la deuxième partie du pilier 60. La stabilité mécanique du pilier 60 est améliorée par rapport à la stabilité mécanique d'un pilier 30 tel que celui représenté sur la figure 1. Le risque d'arrachement du pilier de connexion 60 est considérablement réduit.

La puce électronique 50 comprend en outre une couche d'interface 70 recouvrant la base et la paroi latérale des éléments 61 (i.e. elle recouvre complètement les éléments 61 excepté la face supérieure en contact avec la base 64 du tronc 62) .

Cette couche d'interface 70 joue le rôle de couche de germination (`seed layer') lors de la formation des éléments 61.

Comme la couche d'interface 70 recouvre le ou les éléments 61, elle présente donc une surface développée plus importante que la surface de la couche d'interface 40 en contact avec la base 34 du pilier 30 du composant représenté sur la figure 1.

Ainsi, l'influence de la gravure latérale (`undercut') de la couche d'interface 70 sous le tronc 62 des piliers 60 est considérablement réduite, même pour des piliers de faibles dimensions (typiquement dont le tronc 62 a un diamètre moyen inférieur à 50 µm, voire inférieur ou égal à 25 µm, voire même inférieur ou égal à 15 µm).

A titre d'exemple, pour un pilier 30, tel que représenté sur la figure 1, dont le tronc 32 a un diamètre moyen de 15 µm et pour une couche d'interface 40 de 0,3 µm d'épaisseur, le pourcentage de surface de contact perdue entre le pilier 30 et la couche d'interface 40, à cause de la gravure latérale (`undercut'), serait d'environ 23%.

A titre illustratif et non limitatif, pour un pilier 60, tel que représenté sur la figure 2, dont le tronc 62 a un diamètre de 15 µm et pour une couche d'interface 70 de 0,3 µm d'épaisseur, le pourcentage de surface de contact perdue entre le pilier 60 et la couche d'interface 70, à cause de la gravure latérale (`undercut'), serait uniquement d'environ 8%, 5% et 3% si le pilier comprend, respectivement un élément 61, deux éléments 61 et trois éléments 61, chaque élément 61 ayant un diamètre de 5 µm et une hauteur de 10µm.

Une couche isolante 78 est disposée entre la couche d'interface 70 et le substrat 12 afin d'isoler le substrat 12 des piliers 60.

De plus, le composant comprend une piste de connexion 76 (ou RDL pour `Redistribution layer') sur la structure d'interconnexion 22 et connectant le tronc 62 du pilier 60 à l'une des pistes conductrices 26 dans l'une des ouvertures 28.

Une couche d'interface 70 est également présente entre la piste de connexion 76 et la structure d'interconnexion 22.

Cette couche d'interface 70 joue également le rôle de couche de germination ('seed layer') lors de la formation de la piste de connexion 76.

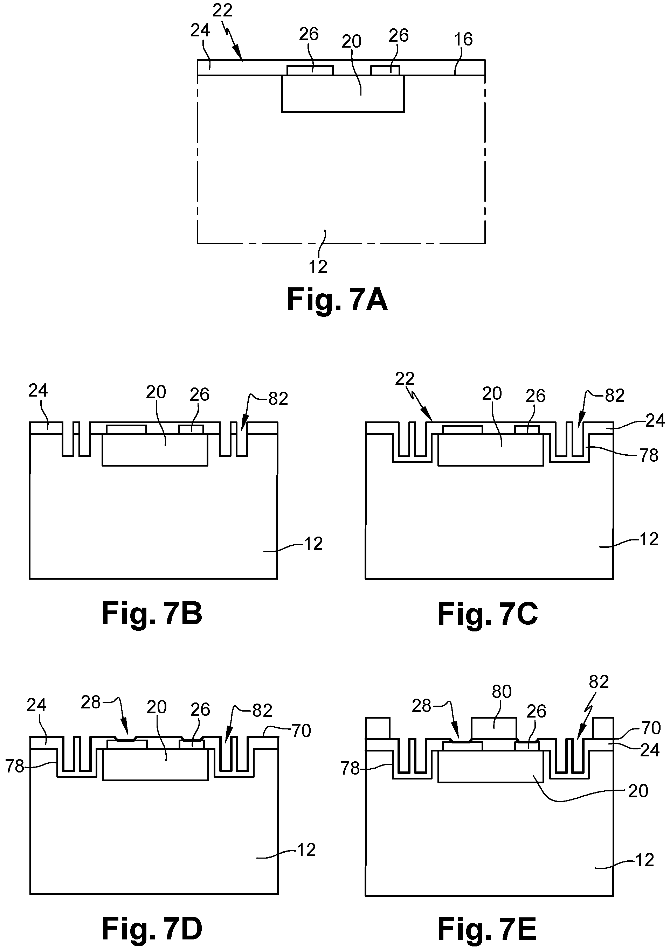

Nous allons maintenant décrire le procédé de fabrication d'une telle puce électronique 50, représentée en figure 2, en faisant référence aux figures 7A à 7H.

Le procédé comprend au moins les étapes suivantes :
- fournir une structure comprenant un substrat 12 dans lequel a été formée une zone active 20, des pistes conductrices 26, étant positionnées dans le substrat 12 ou sur la face supérieure du substrat 12 et étant connectées à la zone active 20,
- recouvrir la face supérieure 16 du substrat 12 par une couche isolante 24,
- former des ouvertures 82 traversant la couche isolante 24 et se prolongeant sur une partie de l'épaisseur du substrat semiconducteur 12,
- former la première partie des piliers conducteurs électriquement 60 en remplissant les ouvertures 82 par un matériau conducteur électriquement,
- former la deuxième partie des piliers conducteurs électriquement 60 à partir de la première partie des piliers.

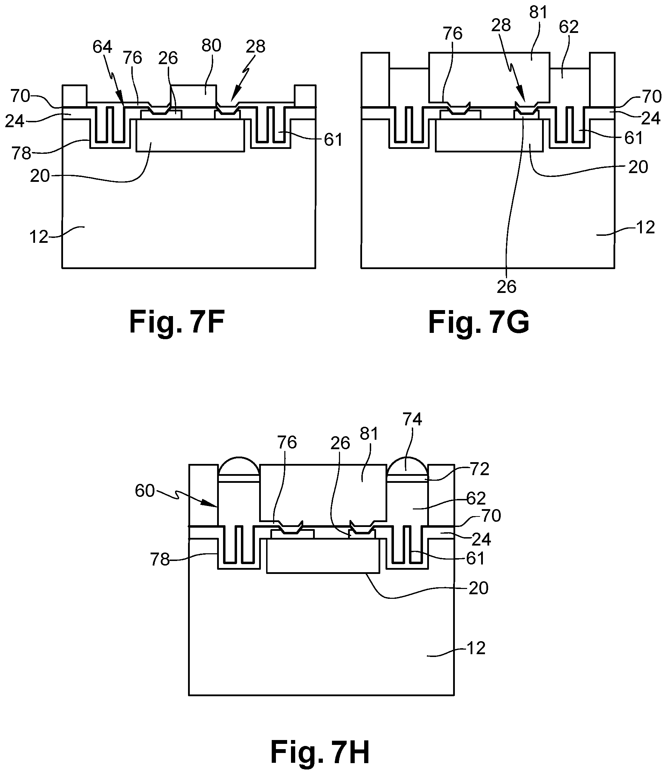

Plus particulièrement, le procédé peut comprendre les étapes suivantes :
a) former une couche isolante 24 sur une structure comprenant un substrat 12 dans lequel a été formée une zone active 20, des pistes conductrices 26 étant positionnées dans le substrat 12 ou sur la face supérieure du substrat 12 et étant connectées à la zone active 20, la couche isolante 24 recouvrant les pistes conductrices 26 et la face supérieure 16 du substrat 12 (figure 7A),
b) former une ou plusieurs ouvertures 82 à l'emplacement souhaité de chaque élément 61 du pilier de connexion 60, les ouvertures traversant la couche isolante 24 et se prolongeant dans le substrat 12 (figure 7B),
c) former une couche isolante 78 dans les ouvertures 82 de manière à isoler le substrat 12 de la deuxième partie des piliers (figure 7C),
d) former des ouvertures 28 dans la couche isolante 24 de manière à rendre accessible les pistes conductrices 26,
e) recouvrir la structure obtenue par une couche d'interface 70 (figure 7D),
f) déposer localement des films de protection 80 sur la structure afin de délimiter les zones sur lesquels le matériau conducteur doit être déposé et de protéger les autres zones (figure 7E),
g) déposer un matériau conducteur pour former le ou les éléments 61 de la deuxième partie du pilier 60, puis pour former les éléments 76 de connexion (figure 7F),
h) déposer localement des films de protection 81 sur la structure obtenue à l'étape f) afin de délimiter les zones sur lesquels le matériau conducteur du tronc 62 des piliers 60 doit être déposé et de protéger les autres zones,
i) faire croître les troncs 62 des piliers 60 à partir des éléments 61 (figure 7G),
j) former, sur la face d'extrémité 66 du tronc 62 du pilier 60, la couche de finition 72 et le bloc 74 du matériau de liaison (figure 7H),
k) retirer les films de protection 81,
l) graver la couche d'interface 70 de manière à isoler électriquement les piliers 60 les uns des autres.

Lors de l'étape a), un ou des composants discrets, non représentés, ont été formés dans et/ou sur la zone active 20. Le ou les composants discrets sont, par exemple, choisis parmi les transistors, diodes, thyristors, triacs, filtres, etc.

Selon un mode de réalisation, à ce stade de la procédure, le substrat 12 correspond à une plaque.

Le substrat 12 est, par exemple, en silicium (Si), en carbure de silicium (SiC), en composé III-V, notamment en nitrure de gallium (GaN), ou en composé II-VI. Le substrat 12 peut avoir une structure monocouche ou multicouches, par exemple une structure du type silicium sur isolant (SOI, sigle anglais pour `Silicon On Insulator'). A titre d'exemple, le substrat 12 peut comprendre une couche de GaN recouvrant un support en silicium. Selon un mode de réalisation, l'épaisseur du substrat 12 est comprise entre 50 µm et 300 µm.

Une seule zone active est représentée sur les figures mais les zones actives 20 de plusieurs puces électroniques peuvent être formées dans et/ou sur le substrat 12, les zones actives 20 pouvant être identiques ou différentes.

En figure 7A, la structure d'interconnexion 22 comprend deux pistes conductrices 26 connectées à la zone active 20 et une couche isolante 24 recouvrant les pistes conductrices 26 et la face supérieure 16 du substrat 12 autour des pistes conductrices 26.

Plus de deux pistes conductrices 26 peuvent être connectées à la zone active 20.

Les pistes conductrices 26 sont, par exemple, en des matériaux choisis parmi le cuivre, un alliage de cuivre, le titane, un alliage de titane, le nitrure de titane, le platine, et un alliage de platine. Il peut également s'agir d'aluminium. Selon un mode de réalisation, l'épaisseur de chaque piste métallique 26 est comprise entre 0,5 µm et 1,5 µm.

La couche isolante 24 peut être un multicouche formé de plusieurs couches isolantes.

La couche isolante 24 peut être en un matériau diélectrique, par exemple un oxyde ou un nitrure, de préférence, il s'agit d'un oxyde de silicium (SiO₂), un nitrure de silicium (par exemple du Si₃N₄), un oxynitrure de silicium (par exemple du Si₂ON₂) ou un oxyde d'hafnium (HfO₂). La couche isolante 24 peut également être en un matériau polymère.

Selon un mode de réalisation, l'épaisseur de la couche isolante 24 est comprise entre 0,5 µm et 1,5 µm.

La figure 7B représente la structure obtenue après la formation d'une ouverture 82 à l'emplacement souhaité de chaque élément 61 du pilier de connexion 60 (étape b)). Les ouvertures 82 traversent complètement la structure d'interconnexion 22 et s'étendent sur une partie de l'épaisseur du substrat 12 depuis la face supérieure 16. Les ouvertures sont des trous borgnes (autrement dit les ouvertures ne traversent pas complètement le substrat 12). La profondeur des ouvertures 82 peut être comprise entre 5 µm et 50 µm.

Une ou plusieurs ouvertures 82 est réalisée pour chaque pilier afin de former, respectivement, un ou plusieurs éléments 61.

Sur les figures, les ouvertures 82 sont à section droite circulaire. Cependant, les ouvertures 82 pourraient être à section droite carrée, section droite rectangulaire ou encore section droite rectangulaire à coins arrondis.

Les ouvertures 82 peuvent être réalisées par gravure laser.

De préférence, les ouvertures 82 sont réalisées par des étapes de gravure ionique réactive profonde (DRIE sigle anglais pour `Deep Reactive Ion Etching').

Pour former les ouvertures 82, un masque pourra être utilisé. La couche 24 est gravée est à travers les ouvertures du masque sur toute son épaisseur. Puis, les ouvertures 82 sont prolongées dans une partie de l'épaisseur du substrat 12. Le masque peut être un masque en résine. Une couche isolante 24, par exemple en oxyde, peut jouer le rôle de masque dur (`Hard Mask') lors de la formation des ouvertures 82 dans le substrat 12.

Lors de l'étape c), la couche isolante 78 est formée dans chaque ouverture. La figure 7C représente la structure obtenue.

La couche isolante 78 recouvre les parois latérales et le fond de l'ouverture 82. La couche isolante 78 peut être formée par dépôt d'une couche isolante dans les ouvertures 82 ou par oxydation du substrat 12. Par exemple, cette étape peut être réalisée par oxydation thermique, oxydation à faible budget thermique (`low thermal oxidation'), par oxydation par voie humide, par dépôt chimique en phase vapeur assisté par plasma (ou PECVD pour `Plasma-Enhanced Chemical Vapor Déposition'). La figure 7C représente le mode de réalisation pour lequel la couche isolante est obtenue par oxydation du substrat 12. L'épaisseur de la couche isolante est choisie de manière à ne pas boucher les ouvertures 82. Elle est par exemple comprise entre 100 nm et 1 µm.

Pour chaque pilier de connexion 60 à réaliser, une ouverture 28 est réalisée dans la couche isolante 24 pour exposer l'une des pistes conductrices 26 (étape d). Ces ouvertures 28 peuvent être réalisées en utilisant un masque.

Lors de l'étape e), une couche d'interface 70 est formée. A ce stade du procédé, la couche d'interface 70 recouvre toutes les parois des cavités 82, notamment les parois latérales et le fond des cavités 82, les parois de l'ouverture 28, et la partie exposée de la couche isolante 24 reliant la cavité 82 à l'ouverture 28 correspondante.

L'épaisseur de la couche d'interface 70 est comprise entre 10 nm et 1 µm. La couche d'interface 70 joue le rôle d'amorce pour la formation du pilier 60 et de la piste de connexion 76 du pilier de connexion 60. La couche d'interface 70 peut comprendre une couche de titane ou de chrome, jouant le rôle de couche d'adhérence, et une couche de cuivre jouant le rôle de couche d'amorce pour la formation ultérieure du tronc 62 et de la piste de connexion 76. La couche d'interface 70 est, de préférence, en TiCu.

Lors de l'étape f), des films de protection 80 sont déposés sur la structure. Ils jouent le rôle de masque lors de la formation des piliers, les piliers 60 étant formés dans les ouvertures du masque.

Lors de l'étape g), le ou les éléments 61 de la deuxième partie des piliers sont formés ainsi que les pistes 76 (figure 7F).

Pour chaque pilier 60 de connexion à réaliser, chaque cavité 82 est remplie complètement par un matériau conducteur, formant ainsi les éléments 61 des piliers de connexion 60. Lorsque les cavités 82 sont remplies, la portion de connexion 76 de chaque pilier de connexion est formée.

Le matériau conducteur composant les éléments 61 peut être déposé sur la couche d'interface 70 par dépôt chimique en phase vapeur assisté par plasma (PECVD) ou par dépôt de couches atomiques (ALD pour `Atomic layer Déposition').

De préférence, le matériau conducteur des éléments 61 est déposé par ALD. La technique ALD est particulièrement intéressante pour remplir des ouvertures de petites dimensions et/ou à fort facteur de forme, c'est-à-dire lorsque le rapport entre la hauteur de la cavité et le diamètre de la cavité est élevé. Dans ce cas, le dépôt du matériau conducteur est réalisé à partir de la couche d'interface 70 selon une direction sensiblement perpendiculaire à la couche d'interface 70. Le dépôt du matériau conducteur est réalisé notamment depuis les parois latérales de la cavité 82.

Le matériau conducteur composant les pistes de connexion 76 peut être déposé sur la couche d'interface 70 par électrodéposition. La croissance se fait à partir de la couche d'interface 70.

L'épaisseur de la couche d'interface est, par exemple, comprise entre 0,3 et 0,9 µm.

Lors de l'étape h), des films de protection 81 sont formés localement sur la structure obtenue à l'étape g).

L'étape h) peut être précédée du retrait des films des protection 80 déposés à l'étape f) ou les films de protection 81 de l'étape h) pouvant être déposés sur les films 81 déposés à l'étape f) de manière à les recouvrir.

Les films de protection 80 formés à l'étape f) et/ou les films de protection 81 formés à l'étape h) sont, par exemple, des résines. Elles peuvent être retirées par gravure humide (`stripping').

Le film de protection 81 comprend des ouvertures aux endroits des positions des troncs 62 des piliers 60 qui seront déposés lors de l'étape i).

La croissance de la première partie des piliers 60 est réalisée, de préférence, par électrodéposition. Le matériau conducteur composant le tronc 62 est déposé à partir de la deuxième partie des piliers 60. La croissance se fait selon une direction sensiblement perpendiculaire aux faces principales 14 et 16 du substrat 12 (figure 7G).

Pour former le tronc 62, il est ainsi possible de déposer le matériau conducteur sensiblement sur une épaisseur égale à la moitié du diamètre moyen des éléments 61. Une fois formé, le tronc 62 se trouve en saillie du côté de la face supérieure 16 du substrat 12.

Le tronc 62 peut avoir une forme sensiblement cylindrique d'axe Δ à base circulaire, carrée, rectangulaire, etc. Le diamètre moyen D du tronc 62 du pilier 60 est compris entre 10 µm et 150 µm. Selon un mode de réalisation, la face d'extrémité 66 est sensiblement perpendiculaire à l'axe Δ.

La hauteur totale H du tronc 62 depuis la base 64 jusqu'à la face d'extrémité 66 est, par exemple, comprise entre 75 µm et 400 µm. La hauteur du tronc 62 se projetant en saillie par rapport à la couche isolante 24 est comprise entre 25 µm et 100 µm. Le rapport d'aspect du tronc 62, qui correspond au rapport entre la hauteur totale H du tronc 62 et le diamètre moyen D du tronc 62, est compris entre 0,5 et 40.

Le tronc 62, les éléments 61 et la piste de connexion 76 sont, de préférence, en un même matériau. Le tronc 62, les éléments 61 et la piste de connexion 76 sont en métal, par exemple en cuivre, en nickel, en argent, en or, ou en un alliage de ces métaux. De préférence, ils sont en cuivre.

Lors de l'étape j), pour chaque pilier de connexion 60, une couche de finition 72 et le bloc 74 du matériau de liaison est formé sur la face d'extrémité 66.

L'épaisseur de la couche de finition 72 est comprise entre 10 nm et 5 µm, par exemple égale à 3 µm. La couche de finition 72 est en un matériau conducteur qui améliore l'adhésion du bloc 74. La couche de finition 72 est par exemple en métal, notamment en or, argent, platine, palladium, nickel, titane, chrome et/ou tantale. De préférence, elle est en nickel. Une telle couche peut être déposée par dépôt physique en phase vapeur (ou PVD pour l'anglais `physical vapor déposition'). La couche de finition 72 permet en outre d'éviter une oxydation de la face d'extrémité 66 du tronc 62 dans le cas où le procédé d'assemblage n'est pas réalisé sous atmosphère neutre ou réductrice.

Le matériau composant le bloc 74 dépend notamment du procédé d'assemblage mis en oeuvre pour la fixation de la puce électronique 50 à un autre élément. Le procédé d'assemblage peut notamment comprendre une étape de soudage ou une étape de frittage.

Le matériau composant le bloc 74 est, par exemple, un matériau de brasage. Il peut s'agir d'étain, d'argent ou d'un de leurs alliages, par exemple SnAgCu, SnAg ou encore SnAgPb. Il peut également s'agir d'un matériau à base d'or, (tel que SnAu ou SnAuCu), à base de palladium (tel que SnPd ou SnPdCu) ou à base de platine (tel que SnPt ou SnPtCu).

La hauteur du bloc 74, mesurée depuis la couche de finition 72 peut être d'environ 25 µm.

Après retrait des films de protection 81 (étape k)), la couche d'interface 70 positionnée entre les piliers, et plus particulièrement entre les pistes de connexion 60 est retirée, de préférence par gravure (étape l)). Le retrait peut être réalisée par gravure par voie humide. La solution de gravure peut être une solution d'acide fluorhydrique (HF) ou une solution d'ammoniaque. La solution de gravure sera choisie en fonction de la nature de la couche de passivation 24 (oxyde ou polymère par exemple).

Le procédé peut, en outre, comprendre une étape de découpe pour séparer les différentes puces électroniques 50 formées dans le même substrat 12.

A l'issue du procédé, une puce telle que représentée sur la figure 2 est obtenue.

Chaque puce électronique 50 ainsi individualisée peut alors être fixée à un élément extérieur, par exemple un boîtier ou une autre puce électronique.

De telles puces électroniques trouvent des applications dans de nombreux domaines industriels, et en particulier, dans le domaine automobile ou le domaine de la téléphonie.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Composant électronique (50), telle qu'une puce électronique, comprenant un substrat semiconducteur (12) ayant des première et deuxième faces (14, 16) opposées et des piliers conducteurs électriquement (60), destinés à être connectés à un élément extérieur au composant électronique, une couche isolante (24) recouvrant la deuxième face (16) du substrat (12), une première partie des piliers conducteurs électriquement (60) se projetant en saillie depuis la couche isolante (24) et une deuxième partie des piliers conducteurs électriquement (60) traversant la couche isolante et s'étendant dans le substrat semiconducteur (12) sur une profondeur inférieure à l'épaisseur du substrat semiconducteur (12),
la deuxième partie des piliers conducteurs électriquement (60) étant formée de plusieurs éléments (61) en contact direct avec une base (64) de la première partie des piliers conducteurs électriquement (60).

2. Composant électronique selon la revendication 1, dans lequel la deuxième partie des piliers conducteurs électriquement (60) est formée de plusieurs éléments (61) cylindriques.

3. Composant électronique selon la revendication 1, dans lequel la deuxième partie des piliers conducteurs électriquement (60) est formée de plusieurs éléments (61) tubulaires disposés de manière coaxiale.

4. Composant électronique selon l'une quelconque des revendications précédentes, comprenant une couche isolante électriquement (78) disposée entre la deuxième partie des piliers conducteurs électriquement (60) et le substrat semiconducteur (12).

5. Composant électronique selon la revendication précédente, comprenant une couche d'interface (70), de préférence en TiCu, en contact avec la deuxième partie des piliers conducteurs électriquement (60), la couche d'interface (70) étant disposée entre les piliers conducteurs électriquement (60) et la couche isolante électriquement (78).

6. Composant électronique selon l'une quelconque des revendications précédentes, comprenant une zone active (20) s'étendant dans le substrat semiconducteur (12) depuis la deuxième face (16) et contenant au moins un composant électronique discret, chaque pilier conducteur électriquement (60) comprenant en outre une piste de connexion (76) s'étendant sur la deuxième face (16) du substrat semiconducteur (12) et connectée électriquement à la zone active (20).

7. Composant électronique selon l'une quelconque des revendications précédentes, dans lequel la première partie des piliers conducteurs électriquement (60) a une hauteur supérieure à 25 µm.

8. Composant électronique selon l'une quelconque des revendications précédentes, dans lequel la deuxième partie des piliers conducteurs électriquement (60) a une hauteur d'au moins 5 µm.

9. Procédé de fabrication d'un composant électronique (50), telle qu'une puce électronique, comprenant un substrat semiconducteur (12) ayant des première et deuxième faces (14, 16) opposées et des piliers conducteurs électriquement (60), destinés à être connectés à un élément extérieur au composant électronique,
le procédé comprenant les étapes suivantes :
- former une couche isolante électriquement (24) sur la deuxième face (16) du substrat semiconducteur (12),
- former des ouvertures (82) traversant la couche isolante (24) et se prolongeant sur une partie de l'épaisseur du substrat semiconducteur (12), plusieurs ouvertures étant réalisées pour chaque pilier conducteur électriquement (60),
- former la première partie des piliers conducteurs électriquement (60) en remplissant les ouvertures (82) par un matériau conducteur électriquement,
- former la deuxième partie des piliers conducteurs électriquement (60) à partir de la première partie des piliers, la deuxième partie des piliers conducteurs électriquement (60) étant formée de plusieurs éléments (61) en contact direct avec une base (64) de la première partie des piliers conducteurs électriquement (60).

10. Procédé selon la revendication 9, comprenant, avant le remplissage des ouvertures (82) par le matériau conducteur électriquement, une étape de formation d'une couche isolante électriquement (78) dans les ouvertures (82).

11. Procédé selon la revendication 10, comprenant, entre l'étape de formation d'une couche isolante électriquement (78) et l'étape de remplissage des ouvertures (82) par le matériau conducteur électriquement, une étape de dépôt d'une couche d'interface (70), de préférence en TiCu, dans les ouvertures (82).
